# EUROPÄISCHE PATENTSCHRIFT

(11) **EP 1 433 204 B1**
(45) Veröffentlichungstag und Bekanntmachung des Hinweises auf die Patenterteilung: **23.11.2005**
(21) Anmeldenummer: 02769935.4
(22) Anmeldetag: 10.09.2002
(51) Int. Cl.: H01L 25/07

(54) **ANORDNUNG MIT LEISTUNGSHALBLEITERBAUELEMENTEN ZUR LEISTUNGSSTEUERUNG HOHER STRÖME UND ANWENDUNG DER ANORDNUNG**
DEVICE WITH POWER SEMICONDUCTOR COMPONENTS FOR CONTROLLING THE POWER OF HIGH CURRENTS AND USE OF SAID DEVICE
DISPOSITIF A COMPOSANTS A SEMI-CONDUCTEUR DE PUISSANCE UTILISE POUR LA REGULATION DE PUISSANCE DE COURANTS ELEVES, ET UTILISATION DUDIT DISPOSITIF

(30) Priorität: 28.09.2001 DE 10147917; 13.03.2002 DE 10211058
(43) Veröffentlichungstag der Anmeldung: 30.06.2004
(73) Patentinhaber: SIEMENS AKTIENGESELLSCHAFT, 80333 München (DE)
(72) Erfinder: SELIGER, Norbert, 81929 München (DE); SCHWARZBAUER, Herbert, 81373 München (DE)
(86) Internationale Anmeldenummer: PCT/DE2002/003354
(87) Internationale Veröffentlichungsnummer: WO 2003/032390

(56) Entgegenhaltungen:
- EP-A- 0 427 143
- EP-A- 1 115 274
- DE-A- 4 327 895

## Beschreibung

Die Erfindung betrifft eine Anordnung mit einem oder mehreren Leistungshalbleiterbauelementen zur Leistungssteuerung hoher Ströme

In der Automobiltechnik werden zunehmend mehr Funktionen durch elektronische Ansteuerung geregelt. So können z.B. der Anlasser und die Lichtmaschine zu einem Aggregat zusammengefasst werden. Die Stromversorgung solcher Systeme erfordert leistungsstärkere Versorgungseinheiten, die wegen ihrer großen thermischen Verlustleistungen eine aktive Kühlung erfordern, die z.B. der Kühlwasserkreislauf bietet.

Die Kühlwassertemperatur kann im Extremfall 125° C erreichen, so dass für alle elektrischen Bauteile nur noch ein sehr kleiner Temperaturhub möglich ist. Wegen der niedrigen Bordnetzspannung von nur 14-42 V sind sehr große Ströme und somit kurze Wege zum Verbraucher nötig. Deswegen sollen die Ansteuereinheiten nahe am Motor, die eine heiße, stark vibrationsbelastete Umgebung darstellt, eingesetzt werden.

Anordnungen mit einem oder mehreren Leistungshalbleiterbauelementen zur Leistungssteuerung hoher Ströme sind üblicherweise modular aufgebaut. Die Leistungshalbleiterbauelemente bzw. Halbleiterschalter sind auf Substraten, meist metallisierte Keramikplättchen, elektrisch isolierend aufgebaut. Diese Untereinheiten sind auf einem Trägerkörper in Form einer kühlbaren Bodenplatte befestigt. Die Stromzuführungen werden durch aufgelötete Metalllaschen, Federkontakte oder Bondungen von den Substraten zu Anschlusspins in einem Gehäuserahmen letztendlich zur Oberseite des Gehäuses geleitet. Die Stromversorgung erfolgt dann oberhalb des Gehäuses durch eine Verschienung oder eine Platine. Dadurch wird auf der Bodenplatte kein Platz für eine Stromverschienung gebraucht und die Baugröße kann klein gehalten werden.

Da nun die elektrischen Anschlussteile z.T. weit oberhalb der Bodenplatte liegen, können sie bei Vibrationen stark schwingen und die Verbindung zum Substrat rasch ermüden.

Es sind auch Aufbauten bekannt, bei denen die und Stromzuführungen für den elektrischen Pluspol "+" und den elektrischen Minuspol "-" antiparallel und isoliert übereinanderliegend (siehe z.B. EP 585578 A1 von Mitsubishi) oder zusätzlich unmittelbar über Substrate geführt werden (siehe z.B. US-Patent Nr. 5 574 312 der ABB Management AG) um die Induktivität des Aufbaues zu minimieren. Auch werden Stützkondensatoren niederinduktiv auf der freien Seite der Verschienung angeordnet (siehe z. B. WO 9 504 448 der KAMAN ELECTROMAGNETICS CORP.) oder ein Kühlkörper schon als stromführendes Teil eingesetzt (siehe z.B. EP 443378 A der REHM SCHWEISSTECHNIK GmbH & Co.).

EP-A-0 427 143 offenbart Anordnungen mit mehreren Leistungshalbleiterbauelementen 20, die auf einer elektrisch leitenden Oberfläche eines gemeinsamen Trägerkörpers angeordnet sind und jeweils wenigstens zwei getrennt voneinander angeordnete elektrische Anschlußflächen aufweisen. Die Bauelemente sind auf der elektrisch leitenden Oberfläche aufgelötet und damit in elektrischen Kontakt mit ihr.

Auf der Oberfläche des Trägerkörpers der bekannten Anordnung neben den Leistungshalbleiterbauelementen und elektrisch von den Bauelementen isoliert sind mehrere getrennt voneinander angeordnete Stromschienen befestigt. Die Leiterbrücken stellen jeweils elektrische Verbindungen zwischen den Kontaktflächen der Bauelemente und verschiedenen Stromschienen her.

Der Erfindung liegt das Problem zugrunde, generell eine Anordnung mit einem oder mehreren Leistungshalbleiterbauelementen zur Leistungssteuerung hoher Ströme bereitzustellen, die dauerhaft in einer stark vibrationsbelasteten Umgebung eingesetzt werden kann.

Dieses Problem wird durch eine Anordnung mit einem oder mehreren Leistungshalbleiterbauelementen zur Leistungssteuerung hoher Ströme gelöst, welche die im Anspruch 1 angegebenen Merkmale aufweist.

Gemäß dieser Lösung ist bei der erfindungsgemäßen Anordnung mit einem oder mehreren Leistungshalbleiterbauelementen zur Leistungssteuerung hoher Ströme
- jedes Leistungshalbleiterbauelement auf einer elektrisch leitenden Oberfläche eines gemeinsamen Trägerkörpers elektrisch von der Oberfläche isoliert befestigt und weist je wenigstens zwei getrennt voneinander angeordnete elektrische Anschlussflächen auf, wobei
- auf dieser Oberfläche des Trägerkörpers neben dem oder den Leistungshalbleiterbauelementen und von jedem Leistungshalbleiterbauelement elektrisch isoliert zwei oder mehr getrennt voneinander und elektrisch voneinander isoliert angeordnete Stromschienen befestigt sind, und wobei
- eine elektrische Anschlussfläche jedes Leistungshalbleiterbauelements durch eine oder mehrere elektrische Leiterbrücken elektrisch mit einer der Stromschienen verbunden ist und eine andere elektrische Anschlussfläche dieses Leistungshalbleiterbauelements durch eine oder mehrere elektrische Leiterbrücken elektrisch mit einer anderen der Stromschienen verbunden ist.

Bei der erfindungsgemäßen Anordnung können vorteilhafterweise die Stromschienen ebenso wie die Leistungshalbleiterbauelemente unmittelbar auf der Oberfläche des Trägerkörpers dicht nebeneinander angeordnet werden. Dadurch bleiben vorteilhafterweise die Schwingungen der Stromschienen und Leistungshalbleiterbauelemente gegeneinander vernachlässigbar klein. Überdies können wegen der dichten Nebeneinanderanordnung der Stromschienen und Leistungshalbleiterbauelemente vorteilhafterweise kurze elektrische Leiterbrücken verwendet werden, die solche Eigenfrequenzen aufweisen, dass sie bei einem üblichen Betrieb der erfindungsgemäßen Anordnung in einer stark vibrierenden Umgebung kaum zur Resonanz angeregt werden können. Aus diesen Gründen ist die erfindungsgemäße Anordnung hervorragend zum dauerhaften Einsatz in einer stark vibrierenden Umgebung, insbesondere in der Nähe eines Antriebsmotors, z.B. einer Brennkraftmaschine eines Kraftfahrzeugs, der bzw. die überdies eine heiße Umgebung darstellt, geeignet.

Die Leistungshalbleiter brauchen bei der erfindungsgemäßen Anordnung vorteilhafterweise nicht verkapselt zu sein, sondern sind bevorzugterweise nackt auf dem Trägerkörper befestigt. Nur die gesamte Anordnung sollte hermetisch dicht in einem Gehäuse hermetisch dicht eingeschlossen sein.

Bevorzugte und vorteilhafte Ausgestaltungen der erfindungsgemäßen Anordnung gehen aus den Ansprüchen 2 bis 23 hervor.

Die Ausgestaltungen nach den Ansprüchen 4 oder 5 mit den übereinander angeordneten Stromschienen ist für einen baulich besonders kompakten Aufbau der erfindungsgemäßen Anordnung vorteilhaft.

Wie schon angedeutet ist eine bevorzugte und vorteilhafte Anwendung der erfindungsgemäßen Anordnung die in einem Motorraum eines Kraftfahrzeugs und insbesondere, aber nicht ausschließlich dort, die Anwendung zur elektrischen Versorgung eines elektrischen Verbrauchers des Kraftfahrzeugs.

Als elektrischer Verbraucher des Kraftfahrzeugs ist beispielhaft und unter anderem zu verstehen: ein Startgenerator, insbesondere bestehend aus Anlasser und Lichtmaschine, eine elektrische aktive Federung, eine elektrische Lenkung, eine elektrische Wasserpumpe, eine elektrische ölpumpe, eine Klimaanlage des Fahrzeugs usw.

Die Erfindung wird in der nachfolgenden Beschreibung anhand der Zeichnungen beispielhaft näher erläutert. Es zeigen:
- Figur 1: eine perspektivische Darstellung einer beispielhaften Ausführungsform erfindungsgemäßen Vorrichtung mit nebeneinander angeordneten Stromschienen,
- Figur 2: eine perspektivische Darstellung einer anderen beispielhaften Ausführungsform erfindungsgemäßen Vorrichtung mit übereinander angeordneten Stromschienen,
- Figur 3: einen vertikalen Schnitt durch einen Teil der Ausführungsform nach Figur 2 längs der Schnittlinie II-II in Figur 2.

Bei den in den Figuren dargestellten beispielhaften Ausführungsformen der erfindungsgemäßen Anordnung ist jedes Leistungshalbleiterbauelement 1 elektrisch isoliert auf einer Oberfläche 20 eines beispielsweise eine Bodenplatte bildenden gemeinsamen Trägerkörpers 2 befestigt.

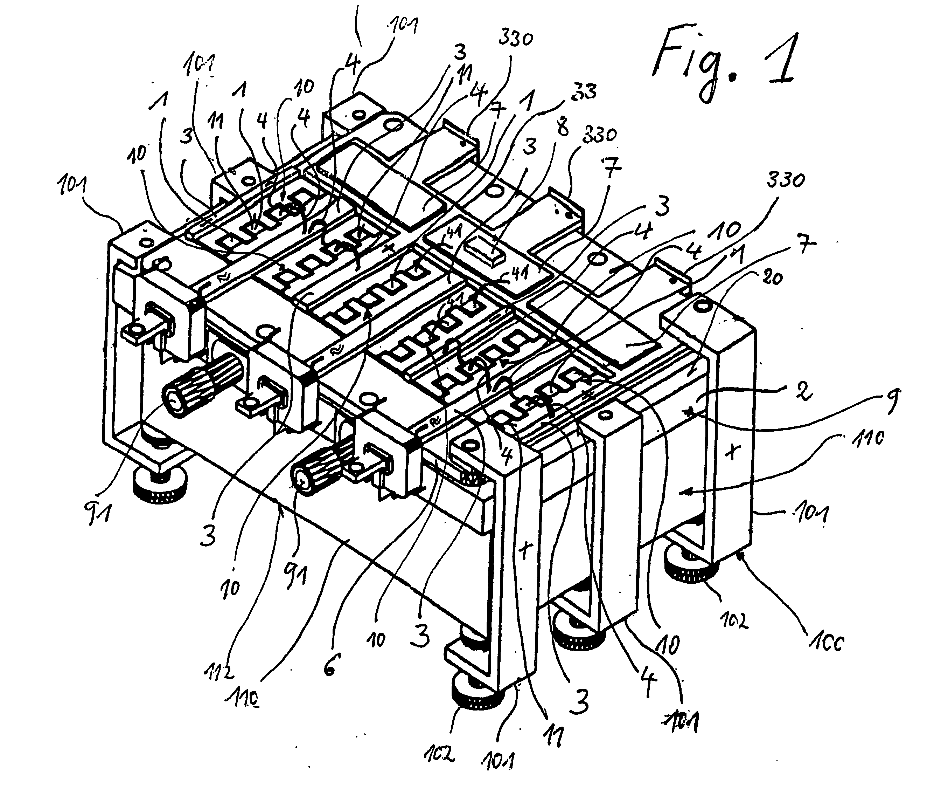

Bei der Ausführungsform nach Figur 1 sind beispielsweise sechs zueinander parallele Reihen 10 aus jeweils vier Leistungshalbleiterbauelementen 1 auf der Oberfläche 20 angeordnet.

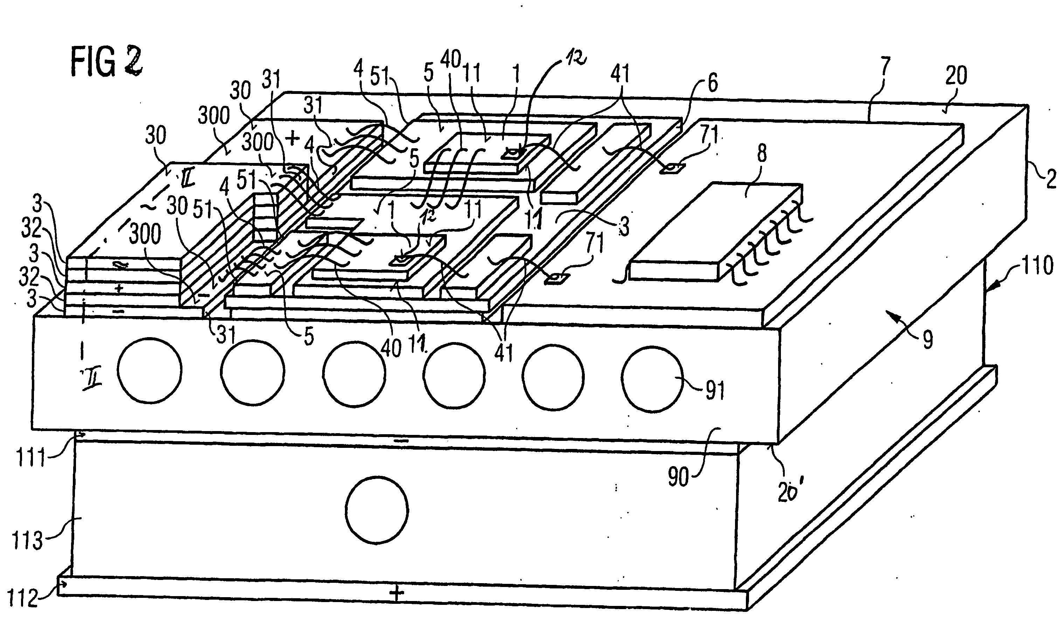

Bei der anderen Ausführungsform nach Figur 2 sind der besseren Übersichtlichkeit halber beispielsweise nur zwei Leistungshalbleiterbauelemente 1 dargestellt. Die Anzahl der Leistungshalbleiterbauelemente 1 könnte auch bei dieser anderen Ausführungsform größer als zwei, beispielsweise ebenso groß wie bei der Ausführungsform nach Figur 1 sein und beispielsweise die gleiche Anordnung wie dort aufweisen.

Generell kann die Anzahl der Leistungshalbleiterbauelemente 1 eine beliebige natürliche Zahl, also auch eins sein, und die Zahl ist oben allenfalls aus technischen Gründen beschränkt.

Jedes Leistungshalbleiterbauelement 1 weist je wenigstens zwei getrennt voneinander angeordnete elektrische Anschlussflächen 11, 11 auf, von denen beispielsweise eine auf einer von der Oberfläche 20 des Trägerkörpers 2 abgekehrten Seite des jeweiligen Leistungshalbleiterbauelements 1 und die andere auf einer der Oberfläche 20 zugekehrten Seite dieses Leistungshalbleiterbauelements 1 angeordnet und in den Figuren 1 und 2 nicht direkt sichtbar ist.

Auf der Oberfläche 20 des Trägerkörpers 2 sind bei jeder der beiden dargestellten Ausführungsformen neben den Leistungshalbleiterbauelementen 1 und elektrisch von jedem Leistungshalbleiterbauelement 1 isoliert mehrere getrennt voneinander angeordnete Stromschienen 3 befestigt.

Ebenso ist bei jeder dargestellten Ausführungsform eine elektrische Anschlussfläche 11 jedes Leistungshalbleiterbauelements 1 durch eine oder mehrere elektrische Leiterbrücken 4 elektrisch mit einer der Stromschienen 3 verbunden und die andere elektrische Anschlussfläche 11 dieses Leistungshalbleiterbauelements 1 durch eine oder mehrere elektrische Leiterbrücken 4 elektrisch mit einer anderen der Stromschienen 3 verbunden.

Insbesondere ist bei jeder der beiden dargestellten Ausführungsformen eine elektrische Anschlussfläche 11 eines Leistungshalbleiterbauelement 1 durch eine oder mehrere elektrische Leiterbrücken 4 elektrisch mit einer einem elektrischen Pol "-"zugeordneten Stromschiene 3 verbunden, eine elektrische Anschlussfläche 11 eines anderen Leistungshalbleiterbauelements 1 durch eine oder mehrere elektrische Leiterbrücken 4 elektrisch mit einer dem zum einen elektrischen Pol "-" entgegengesetzten anderen elektrischen Pol "+" zugeordneten anderen Stromschiene 3 verbunden, und sind die andere elektrische Anschlussfläche 11 des einen Leistungshalbleiterbauelements 1 und die andere elektrische Anschlussfläche 11 des anderen Leistungshalbleiterbauelements 1 durch eine oder mehrere elektrische Leiterbrücken 4 elektrisch mit einer weiteren Stromschiene 3 verbunden.

Beispielsweise ist es bei den Ausführungsformen nach den Figuren 1 und 2 vorzugsweise so eingerichtet, dass jedes Leistungshalbleiterbauelement 1 als ein Schalt- oder Steuerelement ausgebildet ist, bei dem zwischen seiner einen Anschlussfläche 11 und seiner anderen Anschlussfläche 11 ein vom Schalt- oder Steuerzustand des Bauelements 1 abhängiger elektrischer Strom fließt oder auch nicht, und dass das mit der einen Anschlussfläche 11 an die dem einen Pol "-" zugeordnete eine Stromschiene 3 angeschlossene Leistungshalbleiterbauelement 1 und das mit der einen Anschlussfläche 11 an die dem anderen Pol "+" zugeordnete andere Stromschiene 3 angeschlossene Leistungshalbleiterbauelement 1 im Gegentakt zueinander geschaltet oder gesteuert werden, d.h. ein Bauelement 1 wird ausgeschaltet oder zugesteuert während das andere eingeschaltet oder aufgesteuert wird und umgekehrt. Die mit der anderen Anschlussfläche 11 jedes dieser beiden Leistungshalbleiterbauelemente 1 verbundene weitere Stromschiene 3 bildet in diesem Fall speziell eine Stromphasenschiene, die in den Figuren 1 und 2 zusätzlich mit "≈" gekennzeichnet ist.

Die Ausführungsform nach Figur 1 ist beispielsweise so ausgebildet, dass alle Stromschienen 3 nebeneinander und parallel zueinander auf der Oberfläche 20 des Trägerkörpers 2 angeordnet sind.

Speziell ist es bei dieser Ausführungsform so eingerichtet, dass
- zwischen einer in der Figur 1 am weitesten rechts liegenden ersten Stromschiene 3, die dem Pol "+" zugeordnet ist, und einer links davon benachbarten und mit "≈" gekennzeichneten ersten Stromphasenschiene 3 eine erste Reihe 10 aus vier Leistungshalbleiterbauelementen 1 angeordnet ist, dass
- zwischen der ersten Stromphasenschiene 3 und einer links davon benachbarten ersten Stromschiene 3, die dem Pol "-" zugeordnet ist, eine zweite Reihe 10 aus vier Leistungshalbleiterbauelementen 1 angeordnet ist, dass
- zwischen der ersten Stromschiene 3, die dem Pol "-" zugeordnet ist, und einer links davon benachbarten und mit "≈" gekennzeichneten zweiten Stromphasenschiene 3 eine dritte Reihe 10 aus vier Leistungshalbleiterbauelementen 1 angeordnet ist, dass
- zwischen der zweiten Stromphasenschiene 3 und einer links davon benachbarten zweiten Stromschiene 3, die wieder dem Pol "+" zugeordnet ist, eine vierte Reihe 10 aus vier Leistungshalbleiterbauelementen 1 angeordnet ist, dass
- zwischen der zweiten Stromschiene 3, die dem Pol "+" zugeordnet ist, und einer links davon benachbarten und mit "≈" gekennzeichneten dritten Stromphasenschiene 3 eine fünfte Reihe 10 aus vier Leistungshalbleiterbauelementen 1 angeordnet ist, und dass
- zwischen der dritten Stromphasenschiene 3 und einer links davon benachbarten zweiten Stromschiene 3, die wieder dem Pol "-" zugeordnet ist, eine sechste Reihe 10 aus vier Leistungshalbleiterbauelementen 1 angeordnet ist.

Jeweils zwei einander gegenüberliegend angeordnete Leistungshalbleiterbauelemente 1 zweier benachbarter Reihen 10, zwischen denen eine mit "≈" gekennzeichnete Stromphasenschiene 3 angeordnet ist, sind einander zugeordnet und bilden ein Paar von im obigen Sinn im Gegentakt zueinander geschalteter Leistungshalbleiterbauelemente 1.

In der Figur 1 sind zwei solche Paare einander zugeordneter Leistungshalbleiterbauelemente 1 dadurch hervorgehoben, dass ihre Leistungshalbleiterbauelemente 1 als durch einzelne elektrische Leiterbrücken 4 mit den betreffenden Stromschienen 3 verbunden dargestellt sind. Beispielsweise verbindet eine Leiterbrücke 4 eine der Oberfläche 20 des Trägerkörpers 2 zugekehrte elektrische Anschlussfläche 11 jedes Bauelements 1 des betreffenden Paares mit einer Stromschiene 3 und eine andere Leiterbrücke 4 die von der Oberfläche 20 abgekehrte elektrische Anschlussfläche 11 mit der anderen Stromschiene 3. Bei einer praktischen Ausführungsform ist jede einzelne Leiterbrücke 4 vorzugsweise durch je mehrere solcher Brücken 4 realisiert, etwa wie dies in Figur 2 angedeutet ist.

Jede Stromschiene 3 ist vorzugsweise durch einen Stab aus gut elektrisch leitendem Material, beispielsweise Kupfer, realisiert, der einen zum problemlosen Leiten der vorgegebenen hohen Stromstärke ausreichend großen Querschnitt aufweist.

Während die mit "≈ gekennzeichneten Stromphasenschienen 3 durch Einzelstäbe gebildet sind, ist es zweckmäßig, die dem Pol "+" zugeordneten Stromschienen 3 durch eine gemeinsame Stromschiene 33 miteinander zu verbinden. Vorzugsweise ist die gemeinsame Stromschiene 33 eine auf der Oberfläche 20 des Trägerkörpers 2 angeordnete Platte aus gut elektrisch leitendem Material, von der die dem Pol "+" zugeordneten Stromschienen 3 als kammzinkenartige Stäbe vorspringen, wobei Platte und die Stäbe vorzugsweise ein Stück bilden.

Auch die dem Pol "-" zugeordneten Stromschienen 3 sind vorzugsweise durch eine gemeinsame Stromschiene miteinander verbunden sein, die wie die dem Pol "-" zugeordneten Stromschienen 3 von den dem Pol "+" zugeordneten Stromschienen und der gemeinsamen Stromschiene 33 elektrisch isoliert sein muss.

Im Gegensatz zur Ausführungsform nach Figur 1 sind bei der Ausführungsform nach Figur 2 die Stromschienen 3 übereinander und voneinander elektrisch isoliert auf der Oberfläche 20 des Trägerkörpers 2 angeordnet, und jede dieser Stromschienen 3 weist eine freie Anschlussfläche 30 auf, die durch insbesondere mehrere elektrische Leiterbrücken 4 mit einer elektrischen Anschlussfläche 11 zumindest eines Leistungshalbleiterbauelements 1 verbunden ist. Dies ermöglicht vorteilhafterweise einen baulich kompakteren Aufbau der erfindungsgemäßen Anordnung.

Insbesondere ist es bei dieser Ausführungsform möglich, jedes Paar einander zugeordneter Leistungshalbleiterbauelemente 1, die im obigen Sinne im Gegentakt zueinander geschaltet oder gesteuert werden, auf einer und derselben Seite aller Stromschienen 3 anzuordnen, im Gegensatz zur Ausführungsform nach Figur 1, bei der die Leistungshalbleiterbauelemente 1 eines solchen Paares auf beiden Seiten einer Stromphasenschiene 3 angeordnet und zudem noch von zueinander verschiedenen Polen zugeordneten Stromschienen 3 flankiert sind.

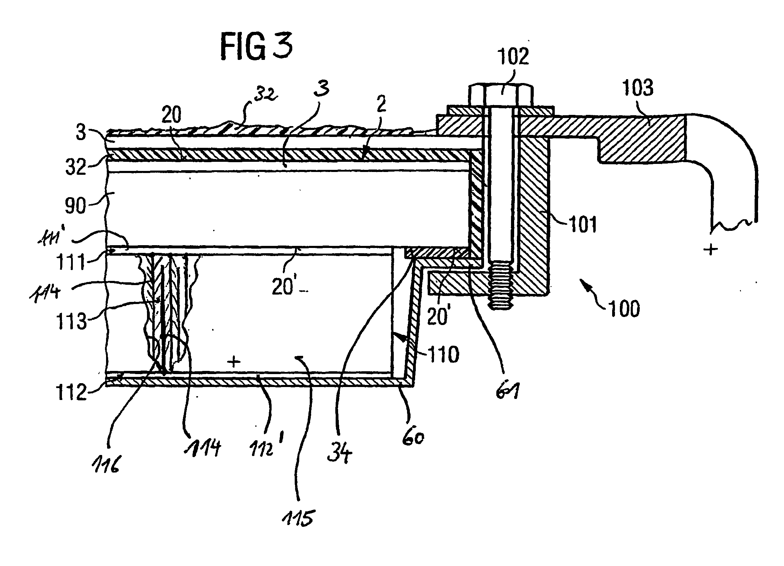

Bei der Ausführungsform nach Figur 2 und 3 ist beispielsweise ein einzelnes Paar solcher Paar Leistungshalbleiterbauelemente 1 auf der rechten Seite der gestapelten Stromschienen 3 angeordnet. Es sind aber, wenn auch nicht dargestellt, vorzugsweise auf dieser rechten Seite zwei oder mehr solche Paare einander zugeordneter Leistungshalbleiterbauelemente 1 entlang den gestapelten Stromschienen 3 nacheinander angeordnet und jeweils in der gleichen Weise wie das in der Figur 2 dargestellte Paar Leistungshalbleiterbauelemente 1 an die gestapelten Stromschienen 3 angeschlossen.

Überdies können solche Paare einander zugeordneter Leistungshalbleiterbauelemente 1 auch auf der von der rechten Seite abgekehrten linken Seite der gestapelten Stromschienen 3 hintereinander angeordnet und in analoger Weise wie das in der Figur 2 dargestellte Paar Leistungshalbleiterbauelemente 1 an die gestapelten Stromschienen 3 angeschlossen sein.

Beispielsweise sind die Leistungshalbleiterbausteine 1 des in Figur 2 dargestellten Paares so an die gestapelten Stromschienen 3 angeschlossen,
- dass eine von der Oberfläche 20 des Trägerkörpers 2 abgekehrte elektrische Anschlussfläche 11 eines Leistungshalbleiterbausteins 1 des Paares durch mehrere Leiterbrücken 4 elektrisch mit der zum Beispiel unmittelbar auf der Oberfläche 20 des Trägerkörpers 2 angeordneten Stromschiene 3, die dem Pol "-" zugeordnet ist, verbunden ist,
- dass eine der Oberfläche 20 des Trägerkörpers 2 zugekehrte elektrische Anschlussfläche 11 des anderen Leistungshalbleiterbausteins 1 des Paares durch mehrere elektrische Leiterbrücken 4 elektrisch mit der zum Beispiel auf der dem Pol "-" zugeordneten Stromschiene 3 angeordneten und von dieser Stromschiene 3 durch eine Schicht 32 aus elektrisch isolierendem Material getrennten Stromschiene 3, die dem Pol "+" zugeordnet ist, verbunden ist,
- dass die der Oberfläche 20 des Trägerkörpers 2 zugekehrte andere elektrische Anschlussfläche 11 des einen Leistungshalbleiterbausteins 1 des Paares durch mehrere elektrische Leiterbrücken 4 elektrisch mit der zum Beispiel auf der dem Pol "+" zugeordneten Stromschiene 3 angeordneten und von dieser Stromschiene 3 durch eine Schicht 32 aus elektrisch isolierendem Material getrennten Stromphasenschiene 3, die durch "≈" gekennzeichnet ist, verbunden ist, und
- dass die von der Oberfläche 20 des Trägerkörpers 2 abgekehrte andere elektrische Anschlussfläche 11 des anderen Leistungshalbleiterbausteins 1 des Paares durch mehrere elektrische Leiterbrücken 4 elektrisch mit dieser Stromphasenschiene 3 verbunden ist.

Eine freie Anschlussfläche 30 einer Stromschiene 3 der gestapelten bzw. übereinander angeordneten Stromschienen 3 ist beispielsweise durch eine über eine auf dieser einen Stromschiene 3 angeordnete andere Stromschiene 3 hinausstehende Oberfläche 300 der einen Stromschiene 3 gebildet, wobei diese Oberfläche 300 eine Randkante 31 aufweist, über die jede elektrische Leiterbrücke 4, welche die freie Anschlussfläche 30 dieser einen Stromschiene 3 mit einer elektrischen Anschlussfläche 11 eines Leistungshalbleiterbauelements 1 elektrisch verbindet, hinweggeführt ist.

Seitlich neben den übereinander angeordneten Stromschienen 3 sind elektrisch isoliert auf der Oberfläche 20 des Trägerkörpers 2 und getrennt von jeder Stromschiene 3 elektrische Zwischenanschlussflächen 5 angeordnet, deren jede elektrisch mit einer Anschlussfläche 11 eines oder mehrerer Leistungshalbleiterbauelemente 1 und durch je mehrere elektrische Leiterbrücken 4 elektrisch mit einer Stromschiene 3 verbunden ist.

Bei der Ausführungsform nach Figur 2 und 3 ist beispielsweise für jedes Leistungshalbleiterbauelement 1 je eine Zwischenanschlussfläche 5 vorgesehen die mit der Oberfläche 20 des Trägerkörpers 2 zugekehrten Anschlussfläche 11 dieses Leistungshalbleiterbauelements 1 in unmittelbarem elektrischen Kontakt steht und an dieser befestigt ist.

Auch ist bei der Ausführungsform nach Figur 2 und 3 beispielsweise eine Zwischenanschlussfläche 5 vorhanden, die von den Anschlussflächen 11 der Leistungshalbleiterbauelemente 1 elektrisch isoliert ist, die aber und durch mehrere elektrische Leiterbrücken 40 elektrisch mit der von der Oberfläche 20 des Trägekörpers 2 abgekehrten Anschlussfläche 11 eines Leistungshalbleiterbauelements 1 verbunden ist.

Speziell ist es bei der Ausführungsform nach Figur 2 und 3 so eingerichtet, dass
- jedes der beiden einander zugeordneten Leistungshalbleiterbauelemente 1 auf je einer diesem Leistungshalbleiterbauelement 1 zugeordneten elektrischen Zwischenanschlussfläche 5 angeordnet ist, so dass die der Oberfläche 20 des Trägerkörpers 2 zugekehrte Anschlussfläche 11 dieses Leistungshalbleiterbauelements 1 und diese zugeordnete Zwischenanschlussfläche 5 in unmittelbarem elektrischen Kontakt miteinander stehen, dass
- eine einem Leistungshalbleiterbauelement 1 zugeordnete Zwischenanschlussflächen 5 durch vorzugsweise mehrere elektrische Leiterbrücken 4 mit einer einem elektrischen Pol, beispielsweise dem Pol "+" zugeordneten Stromschiene 3 elektrisch verbunden ist, dass
- die von der Oberfläche 20 des Trägerkörpers 2 abgekehrte Anschlussfläche 11 dieses einen Leistungshalbleiterbauelements 1 durch vorzugsweise mehrere elektrische Zwischenleiterbrücken 40 mit der dem anderen Leistungshalbleiterbauelement 1 zugeordneten Zwischenanschlussflächen 5 elektrisch verbunden ist, die wiederum durch vorzugsweise mehrere elektrische Leiterbrücken 4 mit der durch "≈" gekennzeichneten Stromphasenschiene 3 elektrisch verbunden ist, und dass
- die von der Oberfläche 20 des Trägerkörpers 2 abgekehrte elektrische Anschlussfläche 11 des anderen Leistungshalbleiterbauelements 1 durch vorzugsweise mehrere elektrische Zwischenleiterbrücken 40 mit einer von den Anschlussflächen 11 der Leistungshalbleiterbauelemente 1 elektrisch isolierten Zwischenanschlussfläche 5 elektrisch verbunden ist, die durch vorzugsweise mehrere elektrische Leiterbrücken 4 mit der dem anderen elektrischen Pol, im Beispiel dem Pol "-" zugeordneten Stromschiene 3 elektrisch verbunden ist.

Jede Zwischenanschlussfläche 5 weist vorzugsweise eine Randkante 51 auf, über die jede an diese Zwischenanschlussfläche 5 angeschlossene elektrische Leiterbrücke 4 oder 40 hinweggeführt ist.

Solche elektrische Zwischenanschlussflächen 5 können, obgleich nicht dargestellt, ebenso gut bei der Ausführungsform nach Figur 1 vorgesehen sein. Beispielsweise können dort die Leistungshalbleiterbauelemente 1 einer oder jeder Reihe 10 auf einer gemeinsamen Zwischenanschlussflächen 5 so angeordnet sein, dass eine der Oberfläche 20 des Trägerkörpers 2 zugekehrte Anschlussfläche 11 jedes Leistungshalbleiterbauelements 1 in unmittelbarem elektrischen Kontakt mit dieser gemeinsamen Zwischenanschlussfläche 5 steht, und die Zwischenanschlussfläche 5 kann durch eine oder mehrere elektrische Leiterbrücken 4 mit einer der beiden Stromschienen 3, zwischen denen diese Reihe 10 angeordnet ist verbunden sein.

Auch kann beispielsweise zwischen einer Stromschiene 3 und einer benachbarten Reihe 10 aus Leistungshalbleiterbauelementen 1 eine von den elektrischen Anschlussflächen 11 der Leistungshalbleiterbauelemente 1 elektrisch isolierte elektrische Zwischenanschlussfläche 5 angeordnet sein, die einerseits durch eine oder mehrere elektrische Leiterbrücken 4 mit dieser Stromschiene 3 und andererseits durch je eine oder mehrere elektrische Zwischenleiterbrücken mit je einer von der Oberfläche 20 des Trägerkörpers 2 abgekehrten Anschlussfläche 11 eines Leistungshalbleiterbauelements 1 elektrisch verbunden sein.

Die Oberfläche 20 des Trägerköpers 2 ist vorzugsweise elektrisch leitend, und jedes Leistungshalbleiterbauelement 1 und jede elektrische Zwischenanschlussfläche 5 ist, wie in Figur 2 gezeigt, durch eine Schicht 6 aus elektrisch isolierendem Material auf der elektrisch leitenden Oberfläche 20 des Trägerköpers 2 von dieser Oberfläche 20 elektrisch isoliert. Die Schicht 6 kann beispielsweise ein Keramik-DCB-Substrat sein.

Bei der Ausführungsform nach Figur 2 und 3 sind beispielsweise alle Leistungshalbleiterbauelemente 1 und alle Zwischenanschlussflächen 5 auf einer gemeinsamen Schicht 6 aus elektrisch isolierendem Material befestigt. Auch bei der Ausführungsform nach Figur 1 sind, wenn auch nicht extra dargestellt, die Leistungshalbleiterbauelemente 1 jeder Reihe 10 und bei dieser Reihe 10 etwa vorhandene Zwischenanschlussflächen 5 auf einer gemeinsamen Schicht 6 aus elektrisch isolierendem Material befestigt.

Die elektrisch leitende Oberfläche 20 des Trägerköpers 2 ist vorzugsweise einem elektrischen Pol zugeordnet, und eine diesem elektrischen Pol zugeordnete Stromschiene 3 ist vorzugsweise unmittelbar mit dieser Oberfläche 20 verbunden, wobei die unmittelbar mit der Oberfläche 20 verbundene Stromschiene 3 durch diese Oberfläche 20 selbst definiert sein kann.

Bei der Ausführungsform nach Figur 2 und 3 ist beispielsweise die elektrisch leitende Oberfläche 20 des Trägerkörpers 2 dem Pol "-" zugeordnet, und die diesem Pol "-" zugeordnete unterste Stromschiene 3 ist unmittelbar auf der elektrisch leitenden Oberfläche 20 des Trägerkörpers 2 befestigt, sie könnte auch durch die elektrisch leitende Oberfläche 20 des Trägerkörpers 2 selbst gebildet sein.

Bei der Ausführungsform nach Figur 1 ist beispielsweise ebenfalls angenommen, dass die elektrisch leitende Oberfläche 20 des Trägerkörpers 2 dem Pol "-" zugeordnet ist, und dass jede die diesem Pol "-" zugeordnete Stromschiene 3 unmittelbar auf der elektrisch leitenden Oberfläche 20 des Trägerkörpers 2 befestigt oder durch diese elektrisch leitende Oberfläche 20 des Trägerkörpers 2 selbst gebildet ist. Die von den dem Pol "-" zugeordneten Stromschienen 3 und voneinander elektrisch getrennten anderen Stromschienen 3, d.h. die dem Pol "+" zugeordneten Stromschienen 3 und die durch "≈" gekennzeichneten Stromphasenschienen 3, müssen von der elektrisch leitenden Oberfläche 20 des Trägerkörpers 3 elektrisch isoliert sein, beispielsweise jeweils durch eine Schicht aus elektrisch isolierendem Material, wie sie bei der Ausführungsform nach Figur 2 und 3 durch eine solche Schicht 32 gegeben ist.

Eine einzelne Stromschiene 3 kann vorteilhafterweise auch bei hohen Strömen von hunderten von Ampere in beispielsweise bis zu 165°C heißer, stark vibrierender Umgebung aus einem dünnen Blech bestehen, wenn für Kühlung gesorgt ist.

Auf der Oberfläche 20 des Trägerkörpers 2 ist eine Platine 7 aus elektrisch isolierendem Material befestigt, auf der wenigstens eine Treiberschaltung 8 und eine oder mehrere elektrische Anschlussflächen 71 befestigt sind, wobei jede Anschlussfläche 71 der Platine 7 durch zumindest eine elektrische Leiterbrücke 41 mit einer Anschlussfläche 12 eines Leistungshalbleiterbauelements 1, die vorzugsweise eine Steueranschlussfläche dieses Bauelements 1 ist, verbunden ist.

In der Figur 1 sind drei Platinen 7 nebeneinander beispielweise auf der gemeinsamen Stromschiene 33 angeordnet, deren jede je einer durch "≈" gekennzeichneten Stromphasenschiene 3 zugeordnet ist. Nur auf der Mittleren Platine 7 ist die Treiberschaltung 8 dieser Platine 7 andeutungsweise dargestellt. Wenn auch nicht dargestellt, so ist in Wirklichkeit auch auf den beiden anderen Platinen 7 je eine solche Treiberschaltung vorhanden. Auch sind in der Figur 1 die auf jeder Platine 7 vorhandenen und den Anschlussflächen 71 der Platine 7 in Figur 2 entsprechenden Anschlussflächen und die auf jedem Leistungshalbleiterbauelement 1 vorhandenen und den Anschlussflächen 12 in Figur 2 entsprechenden Anschlussflächen der Einfachheit halber nicht dargestellt.

Eine dieser Anschlussflächen jeder Platine 7 in Figur 1 ist durch eine elektrische Leiterbrücke 41 mit der dieser Anschlussfläche entsprechenden Anschlussfläche des ersten Leistungshalbleiterbauelements 1 der Reihe 10 auf einer Seite der Stromphasenschiene 3, zu der diese Platine 7 gehört, elektrisch verbunden, und die andere Anschlussfläche dieser Platine 7 ist durch eine elektrische Leiterbrücke 41 mit der dieser Anschlussfläche entsprechenden Anschlussfläche des ersten Leistungshalbleiterbauelement 1 der Reihe 10 auf der anderen Seite dieser Stromphasenschiene 3 elektrisch verbunden. In jedem Paar solcher Reihen 10 sind die einander entsprechenden Anschlussflächen benachbarter Leistungshalbleiterbauelement 1 durch je eine Leiterbrücke 41, von denen in der Figur 1 nur eine dargestellt ist, elektrisch verbunden. In jedem Paar solcher Reihen 10 werden beispielsweise alle Leistungshalbleiterbauelemente 1 einer Reihe 10 im Gegentakt zu allen Leistungshalbleiterbauelementen 1 der anderen Reihe 10 geschaltet oder gesteuert und umgekehrt.

Eine elektrische Leiterbrücke 4, 40 und/oder 41 kann aus einem Bonddraht aus einem insbesondere geschweißten Bändchen besteht oder aus einer Lotbrücke besteht bestehen. Bei Verwendung von Bonddrähten oder Bändchen für die Leiterbrücken 4, 40 empfiehlt es sich wegen des kleinen Querschnitts für den elektrischen Leistungsanschluss einer einzelnen Anschlussfläche 11 eines Leistungshalbleiterbauelements 1 mit einer Zwischenanschlussfläche 5 oder einer Stromschiene 3 ebenso wie für den elektrischen Leistungsanschluss einer einzelnen Zwischenanschlussfläche 5 an eine Stromschiene 3 zwei oder mehr solche Drähte oder Bändchen zu verwenden, wie dies in der Figur 2 dargestellt ist. Eine Lotbrücke kann dagegen mit sehr großem Querschnitt ausgeführt werden, so dass ein elektrischer Leistungsanschluss mit einer einzelnen solchen Lotbrücke hergestellt werden kann.

Zur Kühlung der Anordnung ist der Trägerkörper 2 an eine Wärmesenke 9 gekoppelt, die vorzugsweise einen Kühlkörper 90 aufweist, der unter der Oberfläche 20 des Trägerkörpers 2 thermisch mit dem Trägerkörper 2 verbunden ist. Der Kühlkörper 90 ist vorzugsweise in den Trägerkörper 2 integriert.

Bei einer in der Nähe einer stark vibrierenden heißen Brennkraftmaschine angeordneten beispielhaften erfindungsgemäßen Anordnung sind eine Stromschiene 3 und eine von der Oberfläche 20 des Trägerköpers 2 abgekehrte Oberfläche 20' des Trägerkörpers 2 durch eine den Trägerkörper 2 umgreifende Klemmeinrichtung 100 aus elektrisch leitendem Material zusammengeklemmt, durch die Strom zu oder von der Stromschiene 3 geleitet werden kann.

Außerdem ist beispielsweise an der von der einen Oberfläche 20 des Trägerkörpers 2 abgekehrten Oberfläche 20' des Trägerkörpers 2 ein Kondensator 110 mit zwei durch ein Dielektrikum 113 voneinander isolierten Elektroden 111 und 112 angeordnet, von denen eine Elektrode 111 einem der beiden zueinander entgegengesetzten elektrischen Pole, bei den in den Figuren dargestellten Ausführungsformen beispielsweise dem Pol "-" zugeordnet ist und in flächigem Kontakt mit der von der einen Oberfläche 20 abgekehrten Oberfläche 20' des Trägerkörpers 2 steht, und die andere Elektrode 112 dem anderen elektrischen Pol "+" zugeordnet ist.

Die in flächigem Kontakt mit der von der einen Oberfläche 20 abgekehrten Oberfläche 20`des Trägerkörpers 2 stehende und beispielsweise dem einen elektrischen Pol "-" zugeordnete eine Elektrode 111 des Kondensators 110 ist elektrisch leitend mit einer Stromschiene 3 verbunden, die diesem elektrischen Pol "-" zugeordnet ist, und wobei die andere Elektrode 112 des Kondensators 110 elektrisch leitend mit einer Stromschiene 3 verbunden ist, die dem anderen elektrischen Pol "+" zugeordnet ist.

Eine bevorzugte und vorteilhafte Anwendung der erfindungsgemäßen Anordnung ist die in einem Motorraum eines Kraftfahrzeugs und insbesondere dort die Anwendung zur elektrischen Versorgung eines elektrischen Verbrauchers des Kraftfahrzeugs, wobei unter Verbraucher u.a. die oben schon genannten Einrichtungen eines Kraftfahrzeugs fallen.

Bei einer für eine solche Anwendung bevorzugten Ausgestaltung der erfindungsgemäßen Anordnung sind die eine oder mehreren elektrisch isolierenden Schichten 6 mit den darauf befestigten Leistungshalbleiterbauelementen 1 auf der Oberfläche 20 des in Form einer Bodenplatte ausgebildeten Trägerkörpers 2 aufgebaut. Beispielsweise ist eine Schicht 6 aus elektrisch isolierendem Material verwendet, deren voneinander abgekehrten Flachseiten mit Metall beschichtet sind, wobei diese Schicht 6 mit einer der metallbeschichteten Flachseite flach auf der elektrisch leitenden Oberfläche 20 des Trägerkörpers 2 aufliegt und an diese Oberfläche 20 gelötet ist, während auf der von der Oberfläche 20 abgekehrten anderen metallbeschichteten Flachseite dieser Schicht 6 ein oder mehrere der Leistungshalbleiterbauelemente 1 mit je einer Anschlussfläche 11 flach aufliegen daran festgelötet sind und in der Metallbeschichtung dieser anderen Flachseite Trennkanäle zur Bildung Zwischenanschlussflächen 5 strukturiert sind.

Der Trägerkörper 2 kann auch schon den integrierten Kühlkörper 90 enthalten, der Kanäle 91 zum Durchleiten eines Kühlmittels enthält. Der Trägerkörper besteht beispielsweise aus Metall und ist elektrisch leitend. Er kann zusätzlich als der Pol "-" benutzt werden. Die Stromschienen 3 in Form dünner Bleche sind unmittelbar neben dem oder den Substraten 6 isolierend auf die Oberfläche 20 des Trägerkörpers 2 aufgeklebt oder mit der Stromschiene 3 für den Pol "-" zuunterst aufgelötet. Die Kontaktierung zu dem oder den Substraten in Form der elektrisch isolierenden Schichten 6 erfolgt durch eine Vielzahl der kurzen Leiterbrücken 4 in Form von Bonddrähten, geschweißten Bändchen oder Lotbrücken. Die Treiberschaltungen 8 für die Leistungshalbleitvorzugsweise MOSFETs sind, lassen sich ebenfalls neben den elektrisch isolierenden Schichten 6 auf den Trägerkörper 2 integrieren.

Der einen Stützkondensator bildende Kondensator 110 entwickelt wegen der hohen Rippelströme nicht zu vernachlässigende Verluste, die wegen der ohnehin schon sehr hohen Umgebungstemperatur weggeführt werden müssen. Dazu ist vorteilhafterweise der Kondensator 110 mit der Rückseite des Kühlkörpers 90 in thermischen Kontakt gebracht, z.B. durch Kleben oder Anpressen mit einer als + Pol zu benutzenden Elektrode 112, an der bei der Ausführungsform nach Figur 2 und 3 ganzflächig ein Deckel 60 aus elektrisch leitendem Material anliegt, der mit einem Rand 61 an einer Schicht 34 aus elektrisch isolierendem Material anliegt, die neben der dem Pol "-" zugeordneten Elektrode 111 des Kondensators 110 auf der von der einen Oberfläche 20 abgekehrten und dem Kondensator 110 zugekehrten Oberfläche 20' des Trägerkörpers 2 aufgebracht ist.

Die Elektrode 111 für den Pol "-" des Kondensators 110 steht in direktem flächigen Kontakt mit der dem Kondensator 110 zugekehrten Oberfläche 20' des Trägerkörpers 2. Eine elektrisch leitende Verbindung mit einer dem Pol "+" zugeordneten Stromschiene 3 und zu einem Kabelschuh 103 eines Anschlusskabels erfolgt durch eine Klemmeinrichtung 100, die beispielsweise zum Anschluss an den Pol "+" eine elektrisch leitende, vom Trägerkörper 2 und der dem Pol "-" zugeordneten Elektrode 111 des Kondensators 110 elektrisch isolierte Schraubzwinge 101 mit einer Handhabe 102 aus elektrisch isolierendem Material für einen Zugriff von Hand aufweisen kann, welche den Trägerkörper 2 mit dem Kühlkörper 90 umgreift und den Kondensator 110 durch den Deckel 60 gegen den Trägerkörper 2 drückt.

Eine Klemmeinrichtung 100 kann bei der Ausführungsform nach Figur 2 und 3 auch so wie bei der Ausführungsform nach Figur 1 ausgebildet sein. Bei dieser Ausführungsform weist die Klemmeinrichtung 100 mehrere Zwingen 101 auf, deren jede den Trägerkörper 2 und den Kondensator 110 von der einen Oberfläche 20 des Trägerkörpers 2 bis zu der dem Pol "+" zugeordneten Elektrode 112 des Kondensators 110 umgreift. Eine dem Pol "+" zugeordnete Zwinge 101 ist elektrisch leitend, kontaktiert die diesem Pol "+" zugeordnete Elektrode 112 des Kondensators 110 und eine diesem Pol "+" zugeordnete Stromschiene 3 oder die gemeinsame Stromschiene 33 und ist vom Trägerkörper 2 und der dem Pol "-" zugeordneten Elektrode 111 des Kondensators 110 elektrisch isoliert. Beispielsweise sind zwei solche elektrisch leitenden Zwingen 101 vorgesehen.

Alle anderen Zwingen 101 dienen im Wesentlichen nur zum mechanischen aneinander Befestigen von Trägerkörper 2 und Kondensator 110 und umgreifen jeweils den Trägerkörper 2 und den Kondensator 110 von der einen Oberfläche 20 des Trägerkörpers 2 bis zu der dem Pol "+" zugeordneten Elektrode 112 des Kondensators 110. Ist eine solche mechanische Zwinge 101 elektrisch leitend, muss sie von der dam Pol "+" zugeordneten Elektrode 112 des Kondensators elektrisch isoliert sein.

In der Figur 1 sind zusätzliche Stromschienen 330 in Form von Blechstreifen vorhanden, deren jede zusätzlich die dem Pol "+" zugeordnete Elektrode 112 des Kondensators 110 und die diesem Pol "+" zugeordneten Stromschienen 3, insbesondere über die gemeinsame Stromschiene 33 elektrisch miteinander verbindet und zu einer weiteren Verbesserung der elektrischen Leitfähigkeit zwischen der Elektrode 112 des Kondensators 110 und einer dem Pol "+" zugeordneten Stromschiene 3 beiträgt.

Der Kondensator 110 ist beispielsweise und vorzugsweise so ausgebildet, dass jede Elektrode 111 und 112 aus einer Metallplatte oder -folie 111' bzw. 112' besteht, von der kammzinkenartig dünne flächenförmige und zueinander parallele Lamellen 114 aus Metall senkrecht abstehen, von denen einige in der Figur 3 in einer in Wirklichkeit nicht vorhandenen Öffnung 116 in einer äußeren Wandung 115 des Kondensators 110 im Schnitt zu sehen sind und die senkrecht zu Zeichenebene der Figur 3 stehen. Die beiden Platten 111', 112` sind so zusammengebracht, dass bis auf eine Lamelle an einem Ende jeder Platte jede Lamelle einer Platte zwischen zwei Lamellen der anderen Platte angeordnet und durch das Dielektrikum 113 von diesen beiden Lamellen getrennt ist.

Eine Stromabnahme erfolgt bei den dargestellten Ausführungsformen von den durch "≈" gekennzeichneten Stromphasenschienen 3. Der Pol "-" liegt vorzugsweise auf Masse, der Pol "+" beispielsweise auf 6 V, 12 V oder 42 V.

Es ist zu bedenken, dass alle wasserreichen Teile, die vom Trägerkörper 2 wegführen, bei Vibrationen zu Schwingungen neigen. Dies führt besonders bei den zu erwartenden hohen Temperaturen zu rascher Ermüdung der Verbindungsstellen. Aufgrund der benötigten Ströme von vielen hundert Ampere müssten die Stromzuführungen mit sehr großem Querschnitt ausgeführt werden, damit sie sich in der heißen Umgebung nicht überhitzen. Durch das Aufkleben auf den gekühlten Trägerkörper 2 können die Leistungsverluste abgeführt werden, so dass auch dünne Bleche als Stromschienen 3 genügen. Da die Schienen 3 ebenso wie die Schichten 6 aus isolierendem Material unmittelbar auf dem Trägerkörper 2 und dicht nebeneinander angeordnet sind, bleiben die Schwingungen gegeneinander vernachlässigbar klein. Kurze Leiterbrücken 4, 40, 41 haben solche Eigenfrequenzen, dass sie kaum zur Resonanz angeregt werden können. Durch eine Klemmeinrichtung 100 mit Anschlüssen in Form von elektrisch leitenden Zwingen 101 am Trägerkörper mit dem Kühlkörper 90 wird zusätzlich sichergestellt, dass die dicken Anschlusskabel nicht die aufgeklebten Stromschienen 3 losreißen können.

## Patentansprüche

1. Anordnung mit einem oder mehreren Leistungshalbleiterbauelementen (1) zur Leistungssteuerung hoher Ströme, wobei
- jedes Leistungshalbleiterbauelement (1) auf einer elektrisch leitenden Oberfläche (20) eines gemeinsamen Trägerkörpers (2) elektrisch von der Oberfläche (20) isoliert befestigt ist und je wenigstens zwei getrennt voneinander angeordnete elektrische Anschlussflächen (11, 11) aufweist, wobei
- auf dieser Oberfläche (20) des Trägerkörpers (2) neben dem oder den Leistungshalbleiterbauelementen (1) und von jedem Leistungshalbleiterbauelement (1) elektrisch isoliert zwei oder mehr getrennt voneinander und elektrisch voneinander isoliert angeordnete Stromschienen (3) befestigt sind, und wobei
- eine elektrische Anschlussfläche (11) jedes Leistungshalbleiterbauelements (1) durch eine oder mehrere elektrische Leiterbrücken (4) elektrisch mit einer (3) der Stromschienen (3) verbunden ist und eine andere elektrische Anschlussfläche (11) dieses Leistungshalbleiterbauelements (1) durch eine oder mehrere elektrische Leiterbrücken (4) elektrisch mit einer anderen der Stromschienen (3) verbunden ist.

2. Anordnung nach Anspruch 1, wobei
- eine elektrische Anschlussfläche (11) eines Leistungshalbleiterbauelement (1) durch eine oder mehrere elektrische Leiterbrücken (4) elektrisch mit einer einem elektrischen Pol (-, +) zugeordneten Stromschiene (3) verbunden ist,
- eine elektrische Anschlussfläche (11) eines anderen Leistungshalbleiterbauelements (1) durch eine oder mehrere elektrische Leiterbrücken (4) elektrisch mit einer dem zum einen elektrischen Pol (-; +) entgegengesetzten anderen elektrischen Pol (+; -) zugeordneten anderen Stromschiene (3) verbunden ist, und wobei
- die andere elektrische Anschlussfläche (11) des einen Leistungshalbleiterbauelements (1) und die andere elektrische Anschlussfläche (11) des anderen Leistungshalbleiterbauelements (1) durch eine oder mehrere elektrische Leiterbrücken (4) elektrisch mit einer weiteren Stromschiene (3) verbunden sind.

3. Anordnung nach Anspruch 1 oder 2, wobei zwei oder mehr Stromschienen (3) nebeneinander auf der Oberfläche (20) des Trägerkörpers (2) angeordnet ist.

4. Anordnung nach einem der vorhergehenden Ansprüche, wobei zwei oder mehr Stromschienen (3) übereinander und voneinander elektrisch isoliert auf der Oberfläche (20) des Trägerkörpers (2) angeordnet sind und jede dieser Stromschienen (3) eine freie Anschlussfläche (30) aufweist, die durch eine oder mehrere elektrische Leiterbrücken (4) mit einer elektrischen Anschlussfläche (11) zumindest eines Leistungshalbleiterbauelements (1) verbunden ist.

5. Anordnung nach Anspruch 4, wobei eine freie Anschlussfläche (30) einer Stromschiene (3) der übereinander angeordneten Stromschienen (3) durch eine über eine auf dieser einen Stromschiene (3) angeordnete andere Stromschiene (3) hinausstehende Oberfläche (300) der einen Stromschiene (3) gebildet ist, wobei diese Oberfläche (300) eine Randkante (31) aufweist, über die jede elektrische Leiterbrücke (4), welche die freie Anschlussfläche (30) dieser einen Stromschiene (3) mit einer elektrischen Anschlussfläche (11) eines Leistungshalbleiterbauelements (1) elektrisch verbindet, hinweggeführt ist.

6. Anordnung nach einem der vorhergehenden Ansprüche, wobei seitlich neben einer Stromschiene (3) elektrisch isoliert auf der Oberfläche (20) des Trägerkörpers (2) und getrennt von jeder Stromschiene (3) wenigstens eine elektrische Zwischenanschlussfläche (5) angeordnet ist, die elektrisch mit einer Anschlussfläche (11) eines oder mehrerer Leistungshalbleiterbauelemente (1) und durch eine oder mehrere elektrische Leiterbrücken (4) elektrisch mit einer Stromschiene (3) verbunden ist.

7. Anordnung nach Anspruch 6, wobei eine Zwischenanschlussfläche (5) und eine Anschlussfläche (11) eines Leistungshalbleiterbauelements (1) in unmittelbarem elektrischen Kontakt miteinander stehen und aneinander befestigt sind.

8. Anordnung nach Anspruch 6 oder 7, wobei eine Zwischenanschlussfläche (5) und eine Anschlussfläche (11) eines Leistungshalbleiterbauelements (1) elektrisch voneinander isoliert sind und durch eine oder mehrere elektrische Leiterbrücken (40) elektrisch miteinander verbunden sind.

9. Anordnung nach einem der Ansprüche 6 bis 8, wobei eine Zwischenanschlussfläche (5) eine Randkante (51) aufweist, über die jede an diese Zwischenanschlussfläche (5) angeschlossene elektrische Leiterbrücke (4, 40) hinweggeführt ist.

10. Anordnung nach einem der vorhergehenden Ansprüche, wobei
- die Oberfläche (20) des Trägerköpers (2) elektrisch leitend ist, und wobei
- jedes Leistungshalbleiterbauelement (1) und jede elektrische Zwischenanschlussfläche (5) durch eine Schicht (6) aus elektrisch isolierendem Material auf der elektrisch leitenden Oberfläche (20) des Trägerköpers (2) von dieser Oberfläche (20) elektrisch isoliert ist.

11. Anordnung nach Anspruch 10, wobei zwei oder mehrere Leistungshalbleiterbauelemente (1) und/oder eine oder mehrere Zwischenanschlussflächen (5) auf einer gemeinsamen Schicht (6) aus elektrisch isolierendem Material befestigt sind.

12. Anordnung nach Anspruch 10 oder 11, wobei
- die elektrisch leitende Oberfläche (20) des Trägerköpers (2) einem elektrischen Pol (-, +) zugeordnet ist, und wobei
- eine diesem elektrischen Pol (-; +) zugeordnete Stromschiene (3) unmittelbar mit dieser Oberfläche (20) verbunden ist.

13. Anordnung nach Anspruch 12, wobei die unmittelbar mit der Oberfläche (20) verbundene Stromschiene (3) durch diese Oberfläche (20) selbst definiert ist.

14. Anordnung nach einem der vorhergehenden Ansprüche, wobei auf der Oberfläche (20) des Trägerkörpers (2) eine Platine (7) aus elektrisch isolierendem Material befestigt ist, auf der wenigstens eine Treiberschaltung (8) und eine oder mehrere elektrische Anschlussflächen (71) befestigt sind, wobei jede Anschlussfläche (71) der Platine (7) durch zumindest eine elektrische Leiterbrücke (41) mit einer elektrischen Anschlussfläche (12) eines Leistungshalbleiterbauelements (1) verbunden ist.

15. Anordnung nach einem der vorhergehenden Ansprüche, wobei eine elektrische Leiterbrücke (4, 40, 41) aus einem Bonddraht besteht.

16. Anordnung nach einem der vorhergehenden Ansprüche, wobei eine elektrische Leiterbrücke (4, 40, 41) aus einem Bändchen besteht.

17. Anordnung nach einem der vorhergehenden Ansprüche, wobei eine elektrische Leiterbrücke (4, 40, 41) aus einer Lotbrücke besteht.

18. Anordnung nach einem der vorhergehenden Ansprüche, wobei der Trägerkörper (2) an eine Wärmesenke (9) gekoppelt ist.

19. Anordnung nach Anspruch 18, wobei die Wärmesenke (9) einen Kühlkörper (90) aufweist, der unter der Oberfläche (20) des Trägerkörpers (2) thermisch mit dem Trägerkörper (2) verbunden ist.

20. Anordnung nach Anspruch 19, wobei der Kühlkörper (90) in den Trägerkörper (2) integriert ist.

21. Anordnung nach einem der vorhergehenden Ansprüche, wobei eine Stromschiene (3) und eine von der Oberfläche (20) des Trägerköpers (2) abgekehrte Oberfläche (20') des Trägerkörpers (2) durch eine den Trägerkörper (2) umgreifende Klemmeinrichtung (100) aus elektrisch leitendem Material zusammengeklemmt sind, durch die Strom zu oder von der Stromschiene (3) geleitet werden kann.

22. Anordnung nach einem der vorhergehenden Ansprüche, wobei an einer von der einen Oberfläche (20) des Trägerkörpers (2) abgekehrten Oberfläche (20') des Trägerkörpers (2) ein Kondensator (110) mit zwei durch ein Dielektrikum (113) voneinander isolierten Elektroden (111, 112) angeordnet ist, von denen eine Elektrode (111) einem der beiden zueinander entgegengesetzten elektrischen Polen (-, +) zugeordnet ist und in flächigem Kontakt mit der von der einen Oberfläche (20) abgekehrten Oberfläche (20') des Trägerkörpers (2) steht, und die andere Elektrode (112) dem anderen elektrischen Pol (+, -) zugeordnet ist.

23. Anordnung nach Anspruch 22, wobei die in flächigem Kontakt mit der von der einen Oberfläche (20) abgekehrten Oberfläche (20') des Trägerkörpers (2) stehende und dem einen elektrischen Pol (-, +) zugeordnete eine Elektrode (111) des Kondensators (110) elektrisch leitend mit einer Stromschiene (3) verbunden ist, die diesem elektrischen Pol (-; +) zugeordnet ist, und wobei die andere Elektrode (112) des Kondensators (110) elektrisch leitend mit einer Stromschiene (3) verbunden ist, die dem anderen elektrischen Pol (+ ; -) zugeordnet ist.

24. Anwendung einer Anordnung nach einem der vorhergehenden Ansprüche in einem Motorraum eines Kraftfahrzeugs.

## Claims

1. Arrangement having one or more power semiconductor components (1) for high current power control, wherein
- each power semiconductor component(1) is mounted on an electrically conducting surface (20) of a common supporting structure (2) in a manner which isolates it electrically from said surface (20) and has at least two electrical terminal lands (11, 11) disposed separately from one another, wherein
- two or more conductor bars (3) disposed separately from one another and electrically isolated from one another are mounted on said surface (20) of the supporting structure (2) adjacently to the power semiconductor component(s) (1) and electrically isolated from each power semiconductor component (1), and wherein
- one electrical terminal land (11) of each power semiconductor component (1) is electrically connected by one or more electrical bridging links (4) to one (3) of the conductor bars (3) and another electrical terminal land (11) of said power semiconductor component (1) is electrically connected by one or more electrical bridging links (4) to another of the conductor bars (3).

2. Arrangement according to claim 1, wherein
- one electrical terminal land (11) of one power semiconductor component (1) is electrically connected by one or more electrical bridging links (4) to a conductor bar (3) assigned to one electrical pole (-, +),
- one electrical terminal land (11) of another power semiconductor component (1) is electrically connected by one or more electrical bridging links (4) to a conductor bar (3) assigned to another electrical pole (-; +) opposite to said electrical pole (-; +), and wherein
- the other electrical terminal land (11) of one power semiconductor component and the other electrical terminal land (11) of the other power semiconductor component are electrically connected by one or more electrical bridging links (4) to another conductor bar (3).

3. Arrangement according to claim 1 or 2, wherein two or more conductor bars (3) are disposed adjacently on the surface (20) of the supporting structure (2).

4. Arrangement according to one of the preceding claims, wherein two or more conductor bars (3) are disposed one above the other and electrically isolated from one another on the surface (20) of the supporting structure (2) and each of said conductor bars (3) has a free terminal land (30) which is connected by one or more electrical bridging links (4) to an electrical terminal land (11) of at least one power semiconductor component (1).

5. Arrangement according to claim 4, wherein a free terminal land (30) of one conductor bar (3) of the conductor bars (3) disposed one above the other is formed by a surface (300) of said conductor bar (3) projecting beyond another conductor bar (3) disposed on said conductor bar (3), said surface (300) having a margin edge (31) over which is routed each electrical bridging link (4) electrically connecting the free terminal land (30) of said conductor bar (3) to an electrical terminal land (11) of a power semiconductor component (1).

6. Arrangement according to one of the preceding claims, wherein there is disposed laterally adjacent to a conductor bar (3) in an electrically isolating manner on the surface (20) of the supporting structure (2) and separately from each conductor bar (3) at least one electrical intermediate terminal land (5) which is electrically connected to a terminal land (11) of one or more power semiconductor components (1) and is electrically connected by one or more electrical bridging links (4) to a conductor bar (3).

7. Arrangement according to claim 6, wherein an intermediate terminal land (5) and a terminal land (11) of a power semiconductor component (1) are in direct electrical contact with one another and are fixed to one another.

8. Arrangement according to claim 6 or 7, wherein an intermediate terminal land (5) and a terminal land (11) of a power semiconductor component (1) are electrically isolated from one another and are electrically connected to one another by one or more electrical bridging links (40).

9. Arrangement according to one of claims 6 to 8, wherein an intermediate terminal land (5) has a margin edge (51) over which each electrical bridging link (4, 40) connected to said intermediate terminal land (5) is routed.

10. Arrangement according to one of the claims 6-8,
- wherein the surface (20) of the supporting structure (2) is electrically conducting, and wherein
- each power semiconductor component (1) and each electrical intermediate terminal land (5) is electrically isolated by a layer (6) of electrically isolating material on the electrically conducting surface (20) of the supporting structure (2) from said surface (20).

11. Arrangement according to claim 10, wherein two or more power semiconductor components (1) and/or one or more intermediate terminal lands (5) are mounted on a common layer (6) of electrically isolating material.

12. Arrangement according to claim 10 or 11, wherein
- the electrically conducting surface (20) of the supporting structure (2) is assigned to an electrical pole (-, +), and wherein
- a conductor bar (3) assigned to said electrical pole (-, +) is directly connected to said surface (20).

13. Arrangement according to claim 12, wherein the conductor bar (3) directly connected to the surface (20) is defined by said surface (20) itself.

14. Arrangement according to one of the preceding claims, wherein on the surface (20) of the supporting structure (2) there is mounted a circuit board (7) made of electrically isolating material on which at least one driver circuit (8) and one or more electrical terminal lands (71) are mounted, each terminal land (71) of the circuit board (7) being connected by at least one electrical bridging link (41) to an electrical terminal land (12) of a power semiconductor component (1).

15. Arrangement according to one of the preceding claims, wherein an electrical bridging link (4, 40, 41) consists of a bond wire.

16. Arrangement according to one of the preceding claims, wherein an electrical bridging link (4, 40, 41) consists of a fillet.

17. Arrangement according to one of the preceding claims, wherein an electrical bridging link (4, 40, 41) consists of a soldered link.

18. Arrangement according to one of the preceding claims, wherein the supporting structure (2) is coupled to a heat sink (9).

19. Arrangement according to claim 18, wherein the heat sink (9) has a cooler (90) which is thermally connected to the supporting structure (2) under the surface (20) of the supporting structure (2).

20. Arrangement according to claim 19, wherein the cooler (90) is integrated in the supporting structure (2).

21. Arrangement according to one of the preceding claims, wherein a conductor bar (3) and a surface (20') of the supporting structure (2) facing away from the surface (20) of the supporting structure (2) are clamped together by a clamping device (100) of electrically conducting material which grips around the supporting structure (2) and through which the current can be routed to or from the conductor bar (3).

22. Arrangement according to one of the preceding claims, wherein there is disposed on a surface (20') of the supporting structure (2) facing away from one surface (20) of the supporting structure (2) a capacitor (110) with two electrodes (111, 112) isolated from one another by a dielectric (113), of which one electrode (111) is assigned to one of the two opposite electrical poles (-, +) and is in planar contact with the surface (20') of the supporting structure (2) facing away from the surface (20), and the other electrode (112) is assigned to the other electrical pole (+, -).

23. Arrangement according to claim 22, wherein one electrode (111) of the capacitor (110) in planar contact with the surface (20') of the supporting structure (2) facing away from one surface (20) of the supporting structure (2) and assigned to one electrical pole (-, +) is electrically connected to a conductor bar (3) which is assigned to said electrical pole (- ; +), and wherein the other electrode (112) of the capacitor (110) is electrically connected to a conductor bar (3) which is assigned to the other electrical pole (+; -).

24. Use of an arrangement according to one of the preceding claims in a motor vehicle engine compartment.

## Revendications

1. Ensemble comprenant un ou plusieurs composants à semi-conducteur de puissance (1) pour commander la puissance de courants élevés,
- chaque composant à semi-conducteur de puissance (1) étant fixé sur une surface électriquement conductrice (20) d'un corps de support (2) commun de manière isolée électriquement par rapport à la surface (20) et comportant respectivement au moins deux faces de raccordement électrique (11, 11) disposées de manière à être séparées l'une de l'autre,
- deux rails de courant (3) ou plus, disposés de manière à être séparés les uns des autres et isolés électriquement les uns par rapport aux autres étant fixés sur cette surface (20) du corps de support (2) à côté du ou des composants à semi-conducteur de puissance (1) et de manière isolée électriquement par rapport à chaque composant à semi-conducteur de puissance (1) et
- une face de raccordement électrique (11) de chaque composant à semi-conducteur de puissance (1) étant reliée électriquement, par un ou plusieurs ponts conducteurs électriques (4), à l'un (3) des rails de courant (3) et une autre face de raccordement électrique (11) de ce composant à semi-conducteur de puissance (1) étant reliée électriquement, par un ou plusieurs ponts conducteurs électriques (4), à un autre des rails de courant (3).

2. Ensemble selon la revendication 1,
- une face de raccordement électrique (11) d'un composant à semi-conducteur de puissance (1) étant reliée électriquement, par un ou plusieurs ponts conducteurs électriques (4), à un rail de courant (3) affecté à un pôle électrique (-, +),
- une face de raccordement électrique (11) d'un autre composant à semi-conducteur de puissance (1) étant reliée électriquement, par un ou plusieurs ponts conducteurs électriques (4), à un autre rail de courant (3) affecté à l'autre pôle électrique (+, -) opposé à l'un pôle électrique (-, +) et
- l'autre face de raccordement électrique (11) de l'un composant à semi-conducteur de puissance (1) et l'autre face de raccordement électrique (11) de l'autre composant à semi-conducteur de puissance (1) étant reliées électriquement, par un ou plusieurs ponts conducteurs électriques (4), à un autre rail de courant (3).

3. Ensemble selon la revendication 1 ou 2, deux rails de courant (3) ou plus étant disposés côté à côte sur la surface (20) du corps de support (2).

4. Ensemble selon l'une des revendications précédentes, deux rails de courant (3) ou plus étant disposés de manière superposée et isolée électriquement l'uns par rapport à l'autre sur la surface (20) du corps de support (2) et chacun de ces rails de courant (3) comportant une face de raccordement libre (30) qui est reliée, par un ou plusieurs ponts conducteurs électriques (4), à une face de raccordement électrique (11) d'au moins un composant à semi-conducteur de puissance (1).

5. Ensemble selon la revendication 4, une face de raccordement libre (30) d'un rail de courant (3) des rails de courant superposés (3) étant constituée par une surface (300) de l'un rail de courant (3), laquelle dépasse un autre rail de courant (3) disposé sur cet un rail de courant (3), cette surface (300) présentant une arête de bord (31) par laquelle passe chaque pont conducteur électrique (4) qui relie électriquement la face de raccordement libre (30) de cet un rail de courant (3) à une face de raccordement électrique (11) d'un composant à semi-conducteur de puissance (1).

6. Ensemble selon l'une des revendications précédentes, au moins une face de raccordement électrique intermédiaire (5) étant disposée latéralement à côté d'un rail de courant (3) de manière isolée électriquement sur la surface (20) du corps de support (2) et séparée de chaque rail de courant (3), laquelle face est reliée électriquement à une face de raccordement (11) d'un ou de plusieurs composants à semi-conducteur de puissance (1) et électriquement à un rail de courant (3) par un ou plusieurs ponts conducteurs électriques (4).

7. Ensemble selon la revendication 6, une face de raccordement intermédiaire (5) et une face de raccordement (11) d'un composant à semi-conducteur de puissance (1) se trouvant en contact électrique direct l'une avec l'autre et étant fixées l'une à l'autre.

8. Ensemble selon la revendication 6 ou 7, une face de raccordement intermédiaire (5) et une face de raccordement (11) d'un composant à semi-conducteur de puissance (1) étant isolées électriquement l'une par rapport à l'autre et étant reliées électriquement entre elles par un ou plusieurs ponts conducteurs électriques (40).

9. Ensemble selon l'une des revendications 6 à 8, une face de raccordement intermédiaire (5) présentant une arête de bord (51) par laquelle passe chaque pont conducteur électrique (4, 40) raccordé à cette face de raccordement intermédiaire (5).

10. Ensemble selon l'une des revendications 6 à 8,
- la surface (20) du corps de support (2) étant électriquement conductrice et
- chaque composant à semi-conducteur de puissance (1) et chaque face de raccordement électrique intermédiaire (5) étant isolés électriquement, par une couche (6) en matière électriquement isolante sur la surface électriquement isolante (20) du corps de support (2), par rapport à cette surface (20).

11. Ensemble selon la revendication 10, deux ou plusieurs composants à semi-conducteur de puissance (1) et/ou une ou plusieurs faces de raccordement intermédiaires (5) étant fixés sur une couche commune (6) en matière électriquement isolante.

12. Ensemble selon la revendication 10 ou 11,
- la surface électriquement conductrice (20) du corps de support (2) étant affectée à un pôle électrique (-, +) et
- un rail de courant (3) affecté à ce pôle électrique (-, +) étant relié directement à cette surface (20).

13. Ensemble selon la revendication 12, le rail de courant (3) relié directement à la surface (20) étant défini par cette surface (20) elle-même.

14. Ensemble selon l'une des revendications précédentes, une platine (7) en matière électriquement isolante étant fixée sur la surface (20) du corps de support (2), platine sur laquelle au moins un circuit pilote (8) et une ou plusieurs faces de raccordement électrique (71) sont fixées, chaque face de raccordement (71) de la platine (7) étant reliée par au moins un pont conducteur électrique (41) à une face de raccordement électrique (12) d'un composant à semi-conducteur de puissance (1).

15. Ensemble selon l'une des revendications précédentes, un pont conducteur électrique (4, 40, 41) se composant d'un fil de bonding.

16. Ensemble selon l'une des revendications précédentes, un pont conducteur électrique (4, 40, 41) se composant d'un ruban.

17. Ensemble selon l'une des revendications précédentes, un pont conducteur électrique (4, 40, 41) se composant d'un pont de soudure.

18. Ensemble selon l'une des revendications précédentes, le corps de support (2) étant couplé à un puits thermique (9).

19. Ensemble selon la revendication 18, le puits thermique (9) comportant un corps de refroidissement (90) qui est relié thermiquement au corps de support (2) en dessous de la surface (20) du corps de support (2).

20. Ensemble selon la revendication 19, le corps de refroidissement (90) étant intégré dans le corps de support (2).

21. Ensemble selon l'une des revendications précédentes, un rail de courant (3) et une surface (20') du corps de support (2), opposée à la surface (20) du corps de support (2), étant serrées ensemble par un équipement de serrage (100) en matière électriquement conductrice, lequel enserre le corps de support (2) et par lequel du courant peut aller vers ou partir du rail de courant (3).

22. Ensemble selon l'une des revendications précédentes, un condensateur (110) avec deux électrodes (111, 112) isolées l'une par rapport à l'autre par un diélectrique (113) étant disposé au niveau d'une surface (20') du corps de support (2) opposée à l'une surface (20) du corps de support (2), dont une électrode (111) est affectée à l'un des deux pôles électriques (-, +) opposés l'un à l'autre et étant en contact plan avec la surface (20') du corps de support (2) opposée à l'une surface (20) et l'autre électrode (112) est affectée à l'autre pôle électrique (+, -).

23. Ensemble selon la revendication 22, l'une électrode (111) du condensateur (110) en contact plan avec la surface (20') du corps de support (2) opposée à l'une surface (20) et affectée à l'un pôle électrique (-, +) étant reliée de manière électriquement conductrice à un rail de courant (3) qui est affecté à ce pôle électrique (-, +) et l'autre électrode (112) du condensateur (110) étant reliée de manière électriquement conductrice à un rail de courant (3) qui est affecté à l'autre pôle électrique (+, -).

24. Application d'un ensemble selon l'une des revendications précédentes dans un compartiment moteur d'un véhicule automobile.
